# EUROPÄISCHE PATENTSCHRIFT

(11) **EP 2 577 773 B1**
(45) Veröffentlichungstag und Bekanntmachung des Hinweises auf die Patenterteilung: **20.08.2014**
(21) Anmeldenummer: 11721434.6
(22) Anmeldetag: 13.05.2011
(51) Int. Cl.: H01M 2/20, H01M 10/48

(54) **UMVERDRAHTUNGSELEMENT FÜR EIN ENERGIESPEICHERMODUL, VERFAHREN ZU DESSEN HERSTELLUNG UND ENERGIESPEICHERMODUL**
REWIRING ELEMENT FOR AN ENERGY STORAGE MODULE, METHOD FOR PRODUCING SAME, AND ENERGY STORAGE MODULE
ELÉMENT DE CÂBLAGE POUR UN MODULE DE STOCKAGE D'ÉNERGIE, PROCÉDÉ DE FABRICATION DUDIT ÉLÉMENT DE CÂBLAGE ET MODULE DE STOCKAGE D'ÉNERGIE

(30) Priorität: 04.06.2010 DE 102010022689
(43) Veröffentlichungstag der Anmeldung: 10.04.2013
(73) Patentinhaber: Bayerische Motoren Werke Aktiengesellschaft, 80809 München (DE)
(72) Erfinder: GOESMANN, Hubertus, 89564 Auernheim (DE); HAUCK, Axelle, 85579 Neubiberg (DE); PETZ, Philipp, 81379 München (DE)
(86) Internationale Anmeldenummer: PCT/EP2011/002370
(87) Internationale Veröffentlichungsnummer: WO 2011/157331

(56) Entgegenhaltungen:
- EP-A2- 2 337 115
- WO-A2-2010/030605
- DE-A1- 10 134 143
- DE-A1- 19 810 746
- DE-A1- 19 847 145
- US-A- 5 618 187
- US-A1- 2009 274 956

## Beschreibung

Die Erfindung betrifft ein Energiespeichermodul-Umverdrahtungselement für ein Energie-speichermodul, das aus mehreren, in zumindest einer vertikalen Reihe übereinander angeordneten Speicherzellen besteht, die paarweise über Zellverbinder elektrisch miteinander verschaltet sind. Die Erfindung betrifft ferner ein Verfahren zur Herstellung eines solchen Energiespeichermodul-Umverdrahtungselements. Weiterhin betrifft die Erfindung ein Energiespeichermodul der oben bezeichneten Art sowie ein Verfahren zu dessen Herstellung.

Speicherzellen, insbesondere solche auf Lithium-Ionen basierenden Speicherzellen, jedoch auch Metall-Hydrid-Speicherzellen (wie Nickel-Metall-Hydrid-Batterien) oder Lithium-Polymer-Speicherzellen oder andere chemische Energiespeicher, erlangen in der Automobilindustrie einen immer höheren Stellenwert. Insbesondere durch den Bedarf an alternativen. Antriebskonzepten, beispielsweise Hybridantrieben oder reinen Elektroantrieben, ist die Speicherung von elektrischer Energie von immenser Bedeutung für den zukünftigen Automobilbau.

Die Verwendung von Lithium-Ionen-Batterien als elektrischer Energiespeicher für Elektromotoren im Automobilbau hat sich als vorteilhaft erwiesen. Zum einen Speichern diese Akkumulatoren eine große Energiemenge bei kleinem Volumen und zum anderen unterliegen solche Batterien nur bedingt einem Alterungsprozess. Insbesondere ein "Memory-Effekt" stellt sich bei diesem nicht ein. Dadurch kann eine Vielzahl von Ladezyklen stattfinden, so dass die Lebensdauer der Batterie der eines Fahrzeugs im Wesentlichen entspricht.

Die meisten Speicherzellen stellen nur geringe Spannungen zwischen einem oder mehreren 10 V zur Verfügung. Diese geringen Spannungen reichen bei Weitem nicht aus, um einen Elektromotor eines Elektrofahrzeugs anzutreiben. Aus diesem Grunde werden Speicherzellen zu sog. Speichermodulen zusammengeschaltet. Hierbei kann eine Mehrzahl von einzelnen Speicherzellen miteinander in Reihe geschaltet werden, wodurch sich die Ausgangsspannung des Speichermoduls entsprechend der Anzahl der in Reihe geschalteten Speicherzellen multipliziert. In einem Speichermodul werden beispielsweise zwölf Speicherzellen miteinander verschaltet. Pro Speicherzellenmodul werden beispielsweise sechs hintereinander angeordnete Speicherzellen in einer Reihe in Serie verschaltet. Eine solche Reihe wird in Serie mit einer zweiten, daneben angeordneten Reihe desselben Speicherzellenmoduls in Serie verschaltet. In einem Kraftfahrzeug kann eine Mehrzahl solcher Speicherzellenmodule vorgesehen und elektrisch miteinander verschaltet sein.

Problematisch bei dem Aufbau eines Speicherzellenmoduls ist jedoch die Kontaktierung von jeweils zwei in Reihe zu schaltenden Speicherzellen an ihren jeweils gegenpoligen Zellterminals (Polen). Durch produktionsbedingte Schwankungen bei der Produktion der Speicherzellen ist der Abstand zwischen zwei benachbart zueinander angeordneten Zellterminals toleranzbehaftet. Dies bedeutet, dass wenn zwei Speicherzellen nebeneinander im Wesentlichen in einer Ebene angeordnet sind, die Zellterminals nicht exakt koplanar zueinander liegen. Weiter erschwerend kommt hinzu, dass sich die Speicherzellen zueinander in ihrem Betrieb zueinander verschieben. Die Verschiebung kann neben einem durch chemische Reaktionen der Speicherzellen verursachten Aufbauchen auch durch unterschiedlich hohe Temperaturen der Speicherzellen bei wechselnden Umgebungsbedingungen verursacht sein.

Da über die gesamte Lebensdauer eines Speichermoduls ein Ausgleich von statischen und dynamischen Verschiebungen gewährleistet sein muss, so dass zulässige Kräfte und Momente an den Zellterminals nicht überschritten werden, müssen die zur Herstellung einer elektrischen Verbindung zwischen zwei Speicherzellen vorgesehenen Zellenverbinder eine Bewegungskompensation bereitstellen.

Aus der DE 20 2009 012 647 U1 ist beispielsweise ein Batteriezellenverbinder bekannt, welcher die Verbindung von Zellterminals aus unterschiedlichen Materialien ermöglicht. Hierzu ist ein erstes Anschlussteil zumindest an der dem Zellterminal zugewandten Seite aus einem ersten elektrisch leitenden Material gebildet. An einem zweiten Anschlussteil ist ein zum Anschluss an einem zweiten Zellterminal gebildetes, zumindest an der dem zweiten Zellterminal zugewandten Seite aus einem zweiten von dem ersten elektrisch leitenden Material verschiedenen elektrisch leitenden Material gebildetes Flachstück stoffschlüssig angeordnet. Um eine erhöhte Flexibilität in der Ebene eines Anschlussteils gewährleisten zu können, wird vorgeschlagen, das die Anschlussteile verbindende Verbindungsteil flexibel auszugestalten. Hierzu kann das Verbindungsteil voneinander beabstandete Rippen aufweisen. Um die Temperatur des Batteriezellenverbinders und damit der jeweiligen Batterien in den Anschlussteilen überwachen zu können, ist ein Verbindungsbereich auf der der Batterie abgewandten Seite eines der Anschlussteile angeordnet. Über diesen Verbindungsbereich kann ein Abgriff zu einem integrierten Schaltkreis oder einer Platine führen, an dem der Abgriff hinsichtlich seiner Temperatur überwachbar ist.

Aufgrund der im Betrieb des Speichermoduls auftretenden statischen und dynamischen Verschiebungen ist eine solche, vorzugsweise stoffschlüssige Verbindung zwischen einem Zellabgriff und einem Verbindungsbereich des Zellverbinders jedoch ebenfalls großen mechanischen Belastungen ausgesetzt. Ein hieraus resultierender Verbindungsbruch könnte zu verfälschten Messergebnissen oder sogar zu einem Ausfall einer Messung führen, wodurch das Speichermodul nicht mehr zuverlässig betreibbar wäre. Dies ist jedoch mit den wirtschaftlichen Anforderungen im Bereich von Kraftfahrzeugen nicht vertretbar.

Ein weiteres, in diesem Zusammenhang bestehendes Problem liegt darin, dass die Herstellung der Verbindung der Spannungsabgriffe mit den jeweiligen Zellverbindern auf möglichst einfache und kostengünstige Weise realisiert werden muss.

Aus der WO 2010/030605 A2 ist ein Batteriemodul mit mehreren elektrochemischen Zellen bekannt. Das Batteriemodul weist eine Leiterplatte auf, an die Anschlüsse der Zellen angeschlossen sind. Zu diesem Zweck weist die Leiterplatte eine Anzahl von Öffnungen auf, die jeweils zur Aufnahme eines der Zellenanschlüsse ausgebildet sind. Um die elektrische Verbindung eines Zellanschlusses mit einer der Öffnungen hinsichtlich in z-Richtung auftretender Vibrationsbelastungen und Unebenheiten zwischen den Zellanschtüssen langfristig stabil zu gestalten, erfolgt die Anbindung des Zellanschlusses an die Öffnung über eine Zwischenscheibe. Die Zwischenscheibe ist derart ausgestaltet, dass sie die in z-Richtung auftretenden Vibrationsbelastungen bzw. Unebenheiten ausgleichen kann. Ein Ausgleich von in anderen als der z-Richtung erfolgenden Belastungen oder Bewegungen ist nicht vorgesehen.

Aus der DE 198 47 145 A1 ist ein Energiespeichermodul-Umverdrahtungselement bekannt, das innerhalb einer Verbindungsplatte eine Struktur aufweist, die aus mehreren nebeneinander angeordneten, sich vertikal erstreckenden Leitungen besteht. Diese Leitungen sind jeweils mit ersten Enden von Spannungsanschlusseinheiten verbunden. Die zweiten Enden der Spannungsanschlusseinheiten sind mit zugehörigen Stromschienen verbunden, über die wiederum benachbarte Batterien in einer vertikalen Reihe verbundn sind. Es sind Maßnahmen beschrieben, mit denen eine Belastung vermindert werden kann, die durch eine äußere, auf einen Teil der Verbindungsplatte ausgeübte Kraft entsteht und die sich innerhalb der Verbindungsplatte ausbreitet. Beispielsweise sind Schlitze in der Verbindungsplatte vorgesehen, durch die erreicht wird, dass.die durch die Kraft verursachte Belastung unterbrochen wird.

Es ist daher Aufgabe der vorliegenden Erfindung, eine Lösung aufzuzeigen, welche die oben genannten Probleme auf möglichst einfache und kostengünstige Weise löst, d.h. ein Energiespeichermodul-Umverdrahtungselement zu schaffen, das einfach und kostengünstig zu realisieren ist, und bei einem besonders kompakten und einfachen Aufbau eine verbesserte Aufnahme von während des Betriebs eines Energiespeichermoduls auftretenden statischen und dynamischen Belastungen ermöglicht.

Diese Aufgabe wird gelöst durch ein Energiespeichermodul-Umverdrahtungselement gemäß den Merkmalen des Patentanspruches 1, ein Verfahren zu seiner Herstellung gemäß den Merkmalen des Patentanspruches 5, ein Energiespeichermodul gemäß den Merkmalen des Patentanspruches 6 sowie ein Verfahren zu dessen Herstellung gemäß den Merkmalen des Patentanspruches 7. Vorteilhafte Ausgestaltungen ergeben sich jeweils aus den abhängigen Patentansprüchen.

Die Erfindung schafft ein Energiespeichermodul-Umverdrahtungselement für ein Energiespeichermodul, das aus mehreren, in zumindest einer vertikalen Reihe übereinander angeordneten Speicherzellen besteht, die paarweise über Zellverbinder elektrisch miteinander verschaltet sind. Das Energiespeichermodul-Umverdrahtungselement umfasst eine Leiterzugstruktur mit mehreren nebeneinander angeordneten und sich vertikal erstreckenden Leiterbahnen. Das Energiespeichermodul-Umverdrahtungselement umfasst weiter mehrere Spannungsabgriffe, deren den Leiterbahnen zugewandte, erste Enden jeweils mit einem zugeordneten ersten Ende einer jeweiligen Leiterbahn verbunden sind, und deren freie, zweite Enden zur stoffschlüssigen Verbindung mit zugeordneten Zellverbindern vorgesehen sind, wobei die Spannungsabgriffe und die.Leiterzugstruktur koplanar oder in parallel verlaufenden Ebenen angeordnet sind. Die ersten Enden der Spannungsabgriffe sind in einem ersten Anschlussabschnitt und die zweiten Enden der Spannungsabgriffe in einem zweiten Anschlussabschnitt angeordnet; wobei der erste und der zweite Anschlussabschnitt aneinander grenzen und wobei bei zumindest manchen der Spannungsabgriffe der erste Anschlussabschnitt in einem Winkel von 45° bis 135°, insbesondere von 90°, zu dem zweiten Anschlussabschnitt angeordnet ist. Erfindungsgemäß sind die Spannungsabgriffe als flexibles Bewegungsausgleichselement ausgebildet, um im Betrieb des Energiespeichermoduls eine Relativbewegung des Energiespeichermodul-Umverdrahtungselements gegenüber den Zellverbindern und/oder unterschiedliche Ausdehnungen des Energiespeichermodul-Umverdrahtungselements und der Zellverbinder auszugleichen, wobei hierzu der erste und der zweite Anschlussabschnitt mit ineinander übergehenden Schlitzen versehen sind, und/oder zumindest manche der Spannungsabgriffe zumindest einen aus der Ebene des jeweiligen Spannungsabgriffs herausragenden Rillenabschnitt aufweisen.

Dadurch, dass die Spannungsabgriffe mit einer Leiterzugstruktur eines Energiespeichermodul-Umverdrahtungselements zu einem vorab hergestellten Halbzeug verbunden sind, vereinfacht sich die Herstellung der elektrischen Verbindung jeweiliger Spannungsabgriffe mit den zugeordneten Zellverbindern, da die Herstellung der Verbindung weitestgehend automatisiert erfolgen kann. Hierdurch lassen sich Kosten sparen Dadurch dass die Spannungsabgriffe und die Leiterzugstruktur koplanar oder in parallel verlaufenden Ebenen angeordnet sind, ergibt sich ein besonders kompaktes und einfach zu handhabendes Energiespeichermodul-Umverdrahtungselement. Die Ausgestaltung der Spannungsabgriffe als flexibles Bewegungsausgleichselement sorgt weiterhin dafür, dass die während des Betriebs eines Energiespeichermoduls auftretenden statischen und dynamischen Belastungen von diesen aufgenommen werden können. Hierdurch werden die Vorzugsweise stoffschlüssigen Verbindungen zwischen den freien zweiten Enden und den zugeordneten Zellverbindern nicht übermäßig mit Kräften beaufschlagt, so dass die Verbindungen von dauerhafter Natur sind. Durch die gewinkelte Ausgestaltung, bei der die ersten Enden der Spannungsabgriffe in einem ersten Anschlussabschnitt und die zweiten Enden der Spannungsabgriffe in einem zweiten Anschlussabschnitt angeordnet sind, wobei der erste und der zweite Anschlussabschnitt aneinander grenzen und wobei bei zumindest manchen der Spannungsabgriffe der erste Anschlussabschnitt in einem Winkel von 45° bis 135°, insbesondere von 90°, zu dem zweiten Anschlussabschnitt angeordnet ist, wird eine flexible Bewegung nicht nur senkrecht zur Ebene der Erstreckung von Leiterzugstruktur und Spannungsabgriffen, sondern auch in der Ebene selbst ermöglicht. Eine Erhöhung der Flexibilität der Spannungsabgriffe ergibt sich dadurch, dass der erste und der zweite Anschlussabschnitt mit einem Schlitz versehen sind, wobei durch die ineinander übergehenden Schlitze die Flexibilität in allen Raumrichtungen maximiert wird. Durch die alternative oder zusätzliche Maßnahme, gemäß der zumindest manche der Spannungsabgriffe zumindest einen aus der Ebene des jeweiligen Spannungsabgriffs herausragenden Rillenabschnitt aufweisen, wird die Elastizität eines jeweiligen Spannungsabgriffs ebenfalls bzw. weiter erhöht. Durch den Rillenabschnitt, z.B. eine oder mehrere Wellen, kann die wirksame, zum Bewegungsausgleich herangezogene, Länge vergrößert werden. Insgesamt wird ein verbesserter Bewegungsausgleich ermöglicht, wenn im Betrieb des Energiespeichermoduls eine statische oder dynamische Bewegung der Speicherzellen relativ zueinander auftritt.

Wenn im Zusammenhang mit den nachfolgenden Ausführungen der abgekürzte Begriff Umverdrahtungselement verwendet wird, so soll es sich dabei im Sinne der Erfindung um ein Energiespeichermodul-Umverdrahtungselement handeln.

Insbesondere ist es zweckmäßig, wenn der erste Anschlussabschnitt eine Verlängerung der Leiterbahn ausbildet, mit der er über sein erstes Ende verbunden ist. Es ist weiterhin vorteilhaft, wenn der erste Anschlussabschnitt und der zweite Anschlussabschnitt in einer gleichen Ebene oder in unterschiedlichen, insbesondere parallelen Ebenen verlaufen. Auch diese Ausgestaltungsvarianten tragen dazu bei, die geometrischen Abmaße des Umverdrahtungselements klein zu halten. Darüber hinaus wird ebenfalls die Handhabung bei der Montage des Umverdrahtungselements vereinfacht, da lediglich ein Anschlussabschnitt der Spannungsabgriffe aus der Erstreckungsrichtung der Leiterbahnen abzweigt.

Besonders zweckmäßig ist es, wenn der zumindest eine Rillenabschnitt in dem zweiten Anschlussabschnitt angeordnet ist. Da der zweite Rillenabschnitt außerhalb der Leiterzugstruktur vorgesehen ist, ist es hier ohne Weiteres möglich, einen aus der Ebene des jeweiligen Spannungsabgriffs herausragenden Abschnitt vorzusehen.

Zweckmäßigerweise sind die Spannungsabgriffe aus Kupfer oder Aluminium oder Legierungen davon gebildet oder damit beschichtet. Vorzugsweise richtet sich das Material der Spannungsabgriffe nach dem Material der Zellverbinder oder des Verbindungsabschnitts an dem Zellverbinder, um eine stoffschlüssige Verbindung auf möglichst einfache und zuverlässige Weise herstellen zu können.

Sofern sich das Material der Leiterzugstruktur und der Zellverbinder (oder des Verbindungsabschnitts an dem Zellverbinder) voneinander unterscheiden und eine stoffschlüssige Verbindung mit beiden Verbindungspartnern hergestellt werden soll, ist es zweckmäßig, wenn die Spannungsabgriffe als Bimetall, insbesondere aus Kupfer und Aluminium oder Legierungen davon, ausgebildet sind. Insbesondere ist es zweckmäßig, wenn das Material der Spannungsabgriffe korrespondierend zu dem Material der Zellverbinder in dem Bereich gewählt ist, in dem eine stoffschlüssige Verbindung erfolgen soll. In diesem Fall kann beispielsweise eine Lötverbindung zwischen den Spannungsabgriffen und der Leiterzugstruktur vorgenommen werden. Ebenso kann eine stoffschlüssige Verbindung des Spannungsabgriffs mit dem Zellverbinder oder dessen Verbindungsbereich durch ein Schweißverfahren, z.B. mittels eines Lasers, vorgenommen werden. Als Schweißverfahren kann ein Reibschweißverfahren verwendet werden. Ebenso kann ein Ultraschallschweißverfahren zur Kontaktierung von Zellverbinder oder Verbindungsbereich und Spannungsabgriff eingesetzt werden. Jedoch ist auch ein Rührreibschweißen, ein torsionales Reibschweißen, ein Rotationsreibschweißen oder ein sonstiges Reibschweißverfahren denkbar. Auch kann ein Multi-Orbital-Reibschweißverfahren eingesetzt werden. Eine stoffschlüssige Verbindung kann auch mittels Widerstandsschweißverfahren hergestellt werden.

Gemäß einer weiteren bevorzugten Ausgestaltung ist die Leiterzugstruktur in und/oder auf einer Trägerplatte ausgebildet. Hierdurch wird der Leiterzugstruktur durch die Trägerplatte, z.B. aus FR4, eine hohe mechanische Stabilität verliehen, wodurch das Handling während der Montage besonders einfach ist. Darüber hinaus können durch die feste Verbindung von Leiterzugstruktur und Trägerplatte relative Bewegungen zwischen einzelnen Leiterbahnen verhindert werden, wodurch beispielsweise auch unter ungünstigen Umständen Kurzschlüsse vermieden werden.

Zweckmäßigerweise weisen die ersten Enden der Spannungsabgriffe zumindest einen, aus der Ebene des jeweiligen Spannungsabgriffs herausragenden, Fuß auf, der durch zugeordnete Aussparungen der Trägerplatte gesteckt ist. Hierdurch können die ersten Enden der Spannungsabgriffe auf einfache Weise mit den jeweiligen Leiterbahnen auf und/oder in der Trägerplatte verlötet werden.

Es ist besonders bevorzugt, wenn eine Mehrzahl an Füßen eines Spannungsabgriffs in Richtung des ersten Anschlussabschnitts hintereinander angeordnet ist. Hierdurch wird eine Ausgleichsbewegung des ersten Anschlussabschnitts in der Ebene der Trägerplatte begünstigt, ohne die Kontaktstellen stark zu beanspruchen.

Gemäß einer weiteren alternativen Ausgestaltung sind die Spannungsabgriffe und die Leiterzugstruktur einstückig ausgebildet. In diesem Fall ist das Umverdrahtungselement ein Stanzbiegeelement, z.B. aus Aluminium oder Kupfer und deren Legierungen. Das Stanzbiegeelement kann aus einem Teil gestanzt werden, wobei die die Flexibilität bewirkenden Wölbungen und/oder Stufen durch Umformverfahren erzeugt werden können. Insbesondere ist es bei einem solchen Stanzbiegeelement möglich, auch die Zellverbinder in das Umverdrahtungselement zu integrieren.

In einer Abwandlung davon könnten die Leiterzugstruktur und die Spannungsabgriffe auch separat hergestellt und miteinander verschweißt werden. Der Vorteil eines als Stanzbiegeelement ausgeführten Umverdrahtungselements besteht darin, dass dieses in der Herstellung kostengünstiger ist als eine Kombination aus Leiterzugstruktur und Leiterplatte.

Die Erfindung schafft weiter ein Verfahren zur Herstellung eines Energiespeichermodul-Umverdrahtungselements der oben bezeichneten Art für ein Energiespeichermodul, das aus mehreren, in zumindest einer vertikalen Reihe übereinander angeordneten Speicherzellen besteht, die paarweise über Zellverbinder elektrisch miteinander verschaltet sind. Das Verfahren weist die folgenden Schritte auf: Herstellen einer Leiterzugstruktur mit mehreren Leiterbahnen; Herstellen mehrerer Spannungsabgriffe, so dass diese als flexibles Bewegungsausgleichselement im Betrieb des Energiespeichermoduls eine Relativbewegung des Umverdrahtungselements gegenüber den Zellverbindern und/oder unterschiedliche Ausdehnungen des Umverdrahtungselements und der Zellverbinder ausgleichen, wobei erste Enden der Spannungsabgriffe in einem ersten Anschlussabschnitt und zweite Enden der Spannungsabgriffe in einem zweiten Anschlussabschnitt angeordnet sind, wobei der erste und der zweite Anschlussabschnitt aneinander grenzen und wobei bei zumindest manchen der Spannungsabgriffe der erste Anschlussabschnitt in einem Winkel von 45° bis 135°, insbesondere von 90°, zu dem zweiten Anschlussabschnitt angeordnet ist, und zudem der erste und der zweite Anschlussabschnitt mit ineinander übergehenden Schlitzen versehen sind, und/oder zumindest manche der Spannungsabgriffe zumindest einen aus der Ebene des jeweiligen Spannungsabgriffs herausragenden Rillenabschnitt aufweisen; jeweils stoffschlüssiges Verbinden der Spannungsabgriffe an den den Leiterbahnen zugewandten, ersten Enden mit einem zugeordneten ersten Ende einer jeweiligen Leiterbahn, wobei die Spannungsabgriffe und die Leiterzugstruktur koplanar oder in parallel verlaufenden Ebenen angeordnet sind. Durch das vorbereitete Halbzeug des Umverdrahtungselements lassen sich die Spannungsabgriffe auf einfache und kostengünstige Weise schnell mit den Zellverbindern des Energiespeichermoduls verbinden, die dann über die Spannungsäbgriffe für jeweilige Speicherzellen abgegriffen werden. Hierdurch ist beispielsweise das Erfassen und Einstellen der Spannung jeder einzelnen Speicherzelle möglich, was unter anderem zur Symmetrierung des Ladezustands eines Energiespeichermoduls notwendig ist. Darüber hinaus kann unter Verwendung der Spannungsabgriffe eine Temperaturüberwachung der Zellverbinder und damit der an die Zellverbinder angeschlossenen Speicherzellen erfolgen.

Die Erfindung schafft darüber hinaus ein Energiespeichermodul, insbesondere für Kraftfahrzeuge. Dieses umfasst mehrere, in zumindest einer vertikalen Reihe übereinander angeordnete Speicherzellen, die paarweise über Zellverbinder elektrisch miteinander verschaltet sind sowie ein Energiespeichermodul-Umverdrahtungselement. Das Energiespeichermodul-Umverdrahtungselement zeichnet sich dadurch aus, dass dieses in der beschriebenen Weise ausgebildet ist, wobei die freien, zweiten Enden der Spannungsabgriffe stoffschlüssig mit zugeordneten Zellverbindern verbunden sind. Wie oben bereits ausgeführt wurde, erfolgt die stoffschlüssige Verbindung vorzugsweise unter Verwendung eines Schweißverfahrens. Bevorzugt wird zur Herstellung der stoffschlüssigen Verbindung ein Laserschweißverfahren eingesetzt.

In einer zweckmäßigen Ausgestaltung ist das Umverdrahtungselement zwischen zwei vertikalen Reihen übereinander angeordneter Speicherzellen angeordnet. Hierdurch kann die Umverdrahtung auf einfache und kompakte Weise in das Energiespeichermodul integriert werden. Darüber hinaus ist ohne Weiteres eine Befestigung des Umverdrahtungselements an einem Halteelement für die Speicherzellen möglich.

Die Erfindung schafft darüber hinaus ein Verfahren zur Herstellung eines Energiespeichermoduls. Das Verfahren umfasst die Schritte: Herstellen eines Energiespeichermodul-Umverdrahtungselements der oben beschriebenen Art; Herstellen eines Energiespeichermoduls mit mehreren, in zumindest einer vertikalen Reihe übereinander angeordneten Speicherzellen, die paarweise über Zellverbinder elektrisch miteinander verschaltet sind; Herstellung einer stoffschlüssigen Verbindung zwischen freien, zweiten Enden der Spannungsabgriffe mit zugeordneten Zellverbindern unter Verwendung eines Laserschweißgeräts.

Die Erfindung wird nachfolgend näher anhand von Ausführungsbeispielen in der Zeichnung erläutert. Gleiche Elemente sind hierbei mit gleichen Bezugszeichen versehen. Es zeigen:
- Fig. 1: eine perspektivische Darstellung eines erfindungsgemäßen Energiespeichermodul-Umverdrahtungselements von einer Vorderseite her,
- Fig. 2: eine perspektivische Darstellung des Energiespeichermodul-Umverdrahtungselements aus Fig. 1 von einer Rückseite her,
- Fig. 3: eine mögliche Ausgestaltungsform eines einzelnen Spannungsabgriffs eines erfindungsgemäßen Energiespeichermodul-Umverdrahtungselements,
- Fig. 4: eine perspektivische Darstellung einer weiteren Ausgestaltungsvariante eines Energiespeichermodul-Umverdrahtungselements,
- Fig. 5: eine Draufsicht auf ein Energiespeichermodul, in dem sechs in einer Spalte über Zellverbinder verschaltbare Speichermodule in zwei Spalten anordenbar sind, und
- Fig. 6: eine Draufsicht auf ein Energiespeichermodul mit sechs in einer Spalte verschalteten Speicherzellen und zwei Spalten, bei dem ein erfindungsgemäßes Energiespeichermodul-Umverdrahtungselement vorgesehen ist.

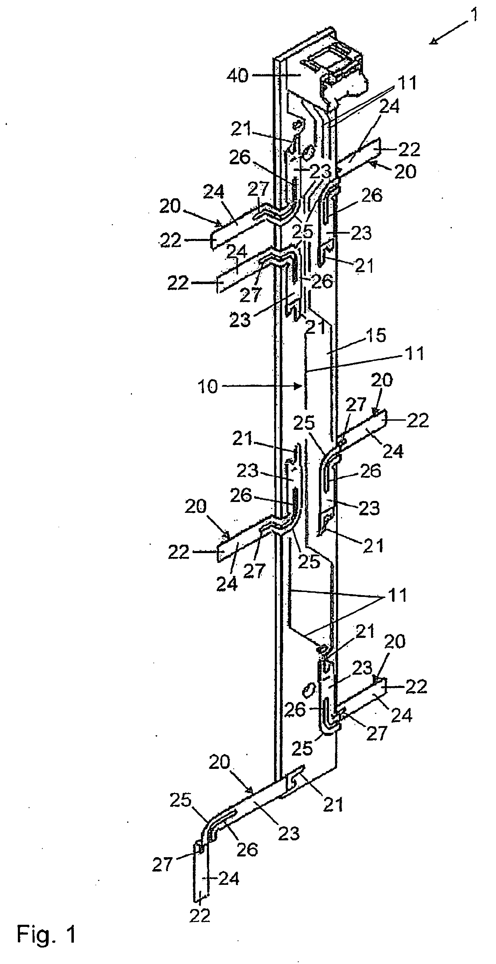

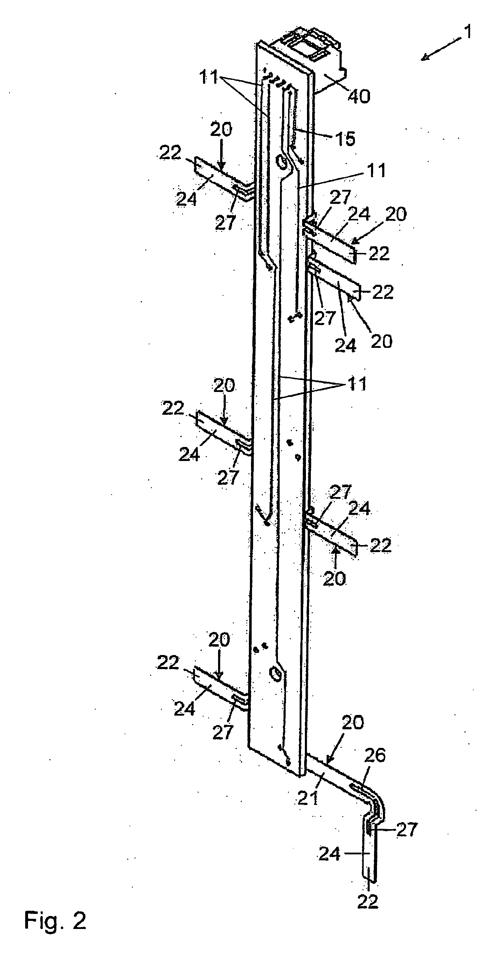

Fig. 1 zeigt eine Ansicht eines erfindungsgemäßen Umverdrahtungselements 1 in einer perspektivischen Darstellung von vorne. Fig. 2 zeigt eine perspektivische Darstellung desselben Umverdrahtungselements 1 in einer perspektivischen Darstellung von hinten. Das Umverdrahtungselement 1 der gezeigten ersten Ausführungsvariante umfasst einen Träger 15, an dem beispielhaft sieben Spannungsabgriffe 20 angeordnet sind. Am oberen Ende des Trägers 15 ist ein Stecker 40 vorgesehen.

Der Träger 15 ist beispielsweise eine Leiterplatte aus FR4 oder einem anderen Leiterplattenmaterial. Auf der in Fig. 1 gezeigten Vorderseite und/oder auf der in Fig. 2 gezeigten Rückseite und/oder im Inneren der Leiterplatte ist eine Leiterzugstruktur 10 mit einer Mehrzahl an Leiterbahnen 11 ausgebildet. Die Leiterbahnen 11 erstrecken sich zumindest abschnittsweise in vertikaler Richtung von dem Stecker 40 zu den Spannungsabgriffen 20 hin, um einen elektrischen Pfad zwischen diesen herzustellen.

Über den Stecker 40 kann das Umverdrahtungselemerit 1 an eine Steuerungseinheit eines Energiespeichermoduls angeschlossen werden. Der Stecker 40 ist ein von dem Träger 15 separat hergestelltes Bauelement, das beispielsweise durch das Umspritzen von Kontaktelementen mit Kunststoff erzeugt werden kann. Ebenso kann dieses auf beliebige andere Weise hergestellt sein. Die Herstellung der elektrischen Verbindung zwischen Kontaktelementen (nicht dargestellt) des Steckers 40 und den im oberen Bereich des Trägers 15 endenden Enden der Leiterbahnen 11 kann beispielsweise, durch einen Lötprozess erfolgen. Selbstverständlich sind auch andere Kontaktierungsarten denkbar.

Jeder der Spannungsabgriffe 20 ist - wie bereits erläutert - mit wenigstens einer Leiterbahn der Leiterzugstruktur des Trägers 15 elektrisch verbunden. Die elektrische Verbindung erfolgt jeweils im Bereich eines ersten Endes 21 des Spannungsabgriffs. Jeweilige freie, zweite Enden 22 der Spannungsabgriffe sind zur stoffschlüssigen Verbindung mit zugeordneten Zellverbindern vorgesehen.

Die Spannungsabgriffe 20 sind als Bewegungsausgleichselemente ausgebildet. Hierdurch sind die Spannungsabgriffe in der Lage, eine Relativbewegung des Umverdrahtungselements gegenüber den Zellverbindern und/oder aufgrund unterschiedlicher Ausdehnungen des Umverdrahtungselements und der Zellverbinder und/oder statischen oder dynamischen Verschiebungen der Speicherzellen des Energiespeichermoduls, in dem das Umverdrahtungselement eingesetzt wird, auszugleichen. Dies bedeutet, die Spannungsabgriffe weisen in allen Raumrichtungen (d.h. in der Ebene des Trägers 15 des Umverdrahtungselements 1 und senkrecht dazu) eine Elastizität auf, welche einerseits zu keiner plastischen Verformung der Spannungsabgriffe führt und andererseits die stoffschlüssige Verbindung zu den Zellverbindern sowie die Verbindung zu den Leiterbahnen mechanisch nicht belastet.

Die Figuren 1 und 2 zeigen eine Möglichkeit, diesen elastischen Bewegungsausgleich mittels der Spannungsabgriffe 20 durch deren geometrische Gestalt bereitzustellen. Hierzu liegen die ersten Enden 21 der Spannungsabgriffe in einem ersten Anschlussabschnitt 23 und die zweiten Enden 22 der Spannungsabgriffe 20 in einem zweiten Anschlussabschnitt 24. Der erste und der zweite Anschlussabschnitt grenzen im Ausführungsbeispiel im 90°-Winkel aneinander. Der gewählte Winkel ist jedoch lediglich beispielhaft. Vielmehr könnten der erste und der zweite Anschlussabschnitt 23, 24 auch in einem anderen Winkel, vorzugsweise im Bereich von 45° bis 135°, zueinander angeordnet sein. Entgegen der zeichnerischen Darstellung ist es auch nicht notwendig, dass sämtliche der Spannungsabgriffe die Gestalt eines "L" aufweisen. Stattdessen könnten auch nur manche der Spannungsabgriffe 20 den gezeigten Verlauf haben. Die gewinkelte Ausgestaltung ermöglicht eine flexible Bewegung von Träger 15 und Zellverbindern sowohl in der Ebene des Trägers 15 als auch senkrecht dazu.

Die Anordnung der zweiten Anschlussabschnitte 24 der Anzahl an Spannungsabgriffen 20 ist durch die Lage und Anordnung der Speicherzellenverbinder und damit der durch die Speicherzellenverbinder elektrisch miteinander verschalteten Speicherzellen vorgegeben. Sofern dies aufgrund der Gegebenheiten möglich ist, ist es bevorzugt, wenn der erste Anschlussabschnitt 23 eine Verlängerung einer jeweiligen kontaktierten Leiterbahn der Leiterzugstruktur (in der Vertikalen) ausbildet. Hiermit ist eine erhöhte Stabilität des Umverdrahtungselements, aber auch eine größere Elastizität verbunden, da die freie, bewegliche Länge zwischen den fixierten ersten und zweiten Enden 21, 22 der Spannungsabgriffe 20 die Flexibilität bestimmt.

In dem in den Figuren 1 und 2 gezeigten Ausführungsbeispiel ist lediglich der in Fig. 1 links unten und in Fig. 2 rechts unten gezeigte Spannungsabgriff 20 derart relativ zu dem Träger 15 angeordnet, dass dessen erster Anschlussabschnitt 23 sich senkrecht (horizontal) zum Verlauf des Trägers 15 erstreckt. Dies ist, wie erläutert, durch die Anordnung und Lage der zu kontaktierenden Zellverbinder bedingt.

Eine weiter verbesserte Flexibilität der Spannungsabgriffe 20 ergibt sich durch das Vorsehen von Schlitzen 26, 27 im ersten und zweiten Anschlussabschnitt 23, 24. Die Schlitze gehen vorzugsweise im Bereich der Winkel ineinander über. Im Ausführungsbeispiel weist jeder der Anschlussabschnitte 23, 24 jeweils einen einzigen Schlitz 26, 27 auf. In einer davon abweichenden Ausgestaltung könnten in jedem Anschlussabschnitt auch mehrere parallel nebeneinander angeordnete dünnere Schlitze vorgesehen sein. Die Schlitze können in die Spannungsabgriffe 20 durch ein Trennverfahren, wie z.B. Stanzen, eingebracht sein. Ebenso ist es möglich, Schlitze mittels eines Lasers in die Spannungsabgriffe einzubringen.

Der erste und der zweite Anschlussabschnitt 23, 24 jeweiliger Spannungsabgriffe 20 sind in dem in den Figuren 1 und 2 gezeigten Ausführungsbeispiel in unterschiedlichen, parallelen Ebenen angeordnet. Hierdurch ergibt sich ein Stufenverlauf der Spannungsabgriffe 20. Der Stufenverlauf kann einerseits durch die geometrischen Gegebenheiten bei der Verbindung des Umverdrahtungselements 1 mit den Zellverbindern des Energiespeichermoduls bedingt sein. Andererseits kann der gestufte Verlauf auch bewusst vorgesehen sein, um die freie Länge zwischen den fixierten ersten und zweiten Enden 21, 22 der Spannungsabgriffe 20 weiter zu erhöhen, wodurch die Flexibilität weiter vorteilhaft verbessert wird.

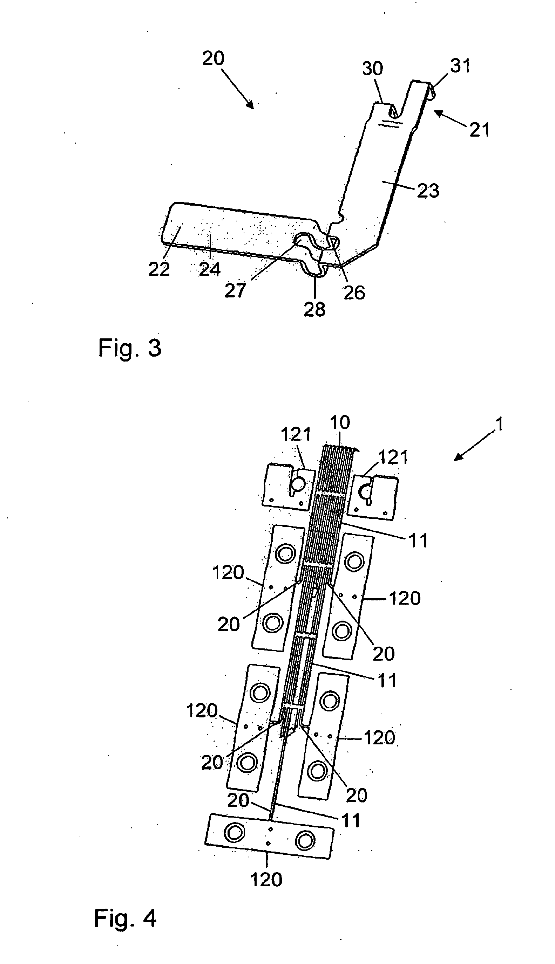

In einer in Fig. 3 perspektivisch dargestellten alternativen Ausgestaltung eines Spannungsabgriffs 20 sind der erste und der zweite Anschlussabschnitt 23, 24 in der gleichen Ebene angeordnet, wobei ein aus der Ebene der Anschlussabschnitte 23, 24 herausragender Rillenabschnitt 28 vorgesehen ist. Auch hierdurch wird die freie Länge zur Verbesserung der Flexibilität zwischen den fixierten ersten und zweiten Enden 21, 22 verlängert. In dem in Fig. 3 gezeigten Ausführungsbeispiel ist lediglich eine einzige Rille vorgesehen. In einer davon abweichenden Ausgestaltung könnte der Spannungsabgriff auch eine Mehrzahl an nebeneinander liegenden Rillen oder Wellen aufweisen. Beispielsweise könnten die Rillen oder Wellen sowohl nach unten als auch nach oben aus der Ebene des ersten und zweiten Anschlussabschnitts 23, 24 herausragen.

Die Rille oder Rillen sind bevorzugt in dem zweiten Anschlussabschnitt angeordnet. Dies ermöglicht zum einen, dass der erste Anschlussabschnitt 23 mit geringem Abstand oder anliegend an den Träger 15 verlaufen kann. Andererseits ist dies durch den Umstand bedingt, dass das Umverdrahtungselement 1 mit seiner Vorderseite voraus an das Speicherzellenmodul angeordnet wird. Mit anderen Worten weist der Stecker 40 in Richtung der Speicherzellen des Energiespeichermoduls. Ein in Richtung des Steckers und damit der Speicherzellen weisender Rillenabschnitt würde das Vorhandensein entsprechenden Leerraums bedingen. Prinzipiell ist jedoch auch eine solche Variante möglich.

Als Material für die Spannungsabgriffe 20 wird vorzugsweise Kupfer oder Aluminium oder eine Legierung davon gewählt. Gegebenenfalls können die Spannungsabgriffe auch aus einem anderen Material bestehen und mit Kupfer oder Aluminium oder Legierungen davon beschichtet sein. Bevorzugt ist das Material der Spannungsabgriffe korrespondierend zu dem Material der Zellverbinder und/oder der zu kontaktierenden Leiterbahnen gewählt, in dem oder den Bereichen eine stoffschlüssige Verbindung erfolgen soll. Sofern Zellverbinder und Leiterbahnen aus unterschiedlichen Materialien bestehen, könnten die Spannungsabgriffe auch als Bimetall ausgebildet sein. In diesem Fall lässt sich auf besonders einfache Weise eine stoffschlüssige Verbindung der ersten und zweiten Enden 21, 22 der Spannungsabgriffe mit den jeweiligen Verbindungspartnern erzielen.

Es ist bevorzugt, wenn die zweiten Enden 22 der Spannungsabgriffe direkt auf den Zellverbinder, oder optional auch direkt auf ein Anschlussterminal der Speicherzelle, geschweißt werden. Bevorzugt erfolgt die Verschweißung unter Verwendung eines Lasers, wobei jedoch auch alle anderen Schweißverfahren, wie z.B. Reibschweißen, Ultraschallschweißen, Rührreibschweißen, torsionales Reibschweißen, Rotationsreibschweißen, Multi-Orbital-Reibschweißen, Widerstandsschweißen, eingesetzt werden können.

Die Herstellung der stoffschlüssigen Verbindung der ersten Enden 21 mit den Leiterbahnen erfolgt bevorzugt durch eine konventionelle Lötung. Zu diesem Zweck weisen die ersten Enden 21 der Spannungsabgriffe 20 zumindest einen, aus der Ebene des jeweiligen Spannungsabgriffs 20 herausragenden Fuß 30, 31 (vgl. Fig. 3) auf, der durch zugeordnete Aussparungen der Trägerplatte gesetzt ist. Die hintereinander angeordneten Füße 30, 31 ermöglichen die Aufnahme von Momenten, wodurch bei einer eventuellen Biegung des Umverdrahtungselements die Lötverbindung zwischen den ersten Enden 31 und der zugeordneten Leiterbahn der Leiterzugstruktur nicht beschädigt wird. Bevorzugt sind die Füße, wie in Fig. 3 exemplarisch dargestellt, in Richtung des ersten Anschlussabschnitts 23 hintereinander angeordnet, da hierdurch die Elastizität im Bereich der Verbindung weiter verbessert wird. Die Lötung der Füße 30, 31 erfolgt von der Rückseite des Trägers 15 her.

Wenn die Spannungsabgriffe 20 aus Kupfer ausgebildet sind, so sind diese mit einer konventionellen Oberfläche (Zinn) versehen. Hierdurch kann beispielsweise eine Lötung im Reflow-Verfahren erfolgen.

Bestehen die Spannungsabgriffe 20 hingegen aus Aluminium, so wird eine Kupfer-Sperrschicht und/oder eine Nickel-Zinn-Oberfläche aufgebracht. Anschließend erfolgt in der beschriebenen Weise ein Durchstecken der Füße durch entsprechende Aussparungen der Leiterplatte 15 und eine Verlötung.

Wie bereits erläutert, ergibt sich die Anzahl und Anordnung der Spannungsabgriffe 20 an dem Träger 15 durch die Anzahl und Gestalt der Speicherverbinder bzw. der diese verbindenden Speicherzellen. Bei einem erfindungsgemäßen Umverdrahtungselement 1 ist pro Zellverbinder mindestens ein Spannungsabgriff vorgesehen. Um eine Redundanz sicherzustellen, ist es vorteilhaft, pro Zellverbinder wenigstens zwei Spannungsabgriffe 20 vorzusehen. Die Funktion eines Spannungsangriffs besteht darin, Messströme zu übertragen, so dass durch die an den Stecker angeschlossene Steuereinheit Mess- und Steuerungsfunktionen übernommen werden können. Insbesondere werden die Spannungsabgriffe dazu verwendet, Temperaturen der Zellverbinder und damit der Speicherzellen zu messen. Darüber hinaus dienen diese dazu, Spannungen der einzelnen Speicherzellen zu messen, um eine Spannungssymmetrierung des Energiespeichermoduls zu erzielen.

Durch die beschriebene Gestalt der Spannungsabgriffe 20 erfolgt ein Ausgleich unterschiedlicher Ausdehnungen des Umverdrahtungselements 1, insbesondere dessen Trägers 15, und den Zellverbindern sowie eines nachfolgend näher beschriebenen Halteelements zur Halterung der Speicherzellen und weiteren Komponenten des Energiespeichermoduls.

Fig. 4 zeigt in einer perspektivischen Darstellung eine alternative Ausgestaltung eines Umverdrahtungselements 1. Bei dieser Ausführungsvariante ist die Leiterzugstruktur nicht in und/oder an einem Träger ausgebildet, sondern durch ein Stanzbiegeelement realisiert. Lediglich schematisch sind einzelne, in vertikaler Richtung parallel verlaufende Leiterbahnen 11 der Leiterzugstruktur 10 ersichtlich. Bei dieser Ausgestaltungsvariante können die Spannungsabgriffe 20 einstückig mit den Leiterbahnen 11 der Leiterzugstruktur 10 ausgebildet sein. Alternativ können die Spannungsabgriffe der oben beschriebenen Art auch durch eine Verschweißung oder Lötung oder auf sonstige Weise elektrisch mit den Leiterbahnen 11 der Leiterzugstruktur verbunden sein. Aus der schematischen Darstellung der Fig. 4 geht weiterhin hervor, dass die zweiten Enden der Spannungsabgriffe 20 auf der in der Figur nicht ersichtlichen Vorderseite der Zellverbinder elektrisch kontaktiert sind. Im gezeigten Ausführungsbeispiel werden durch das Umverdrahtungselement 1 fünf Zellverbinder 120 und im oberen Bereich zwei sog. Modulschwerter 121 über Spannungsabgriffe 20 kontaktiert, welche jeweils mit einem Zellterminal einer Speicherzelle elektrisch verbunden sind. Über die Modulschwerter 121 erfolgt eine elektrische Kontaktierung eines jeweiligen Energiespeichermoduls von außen.

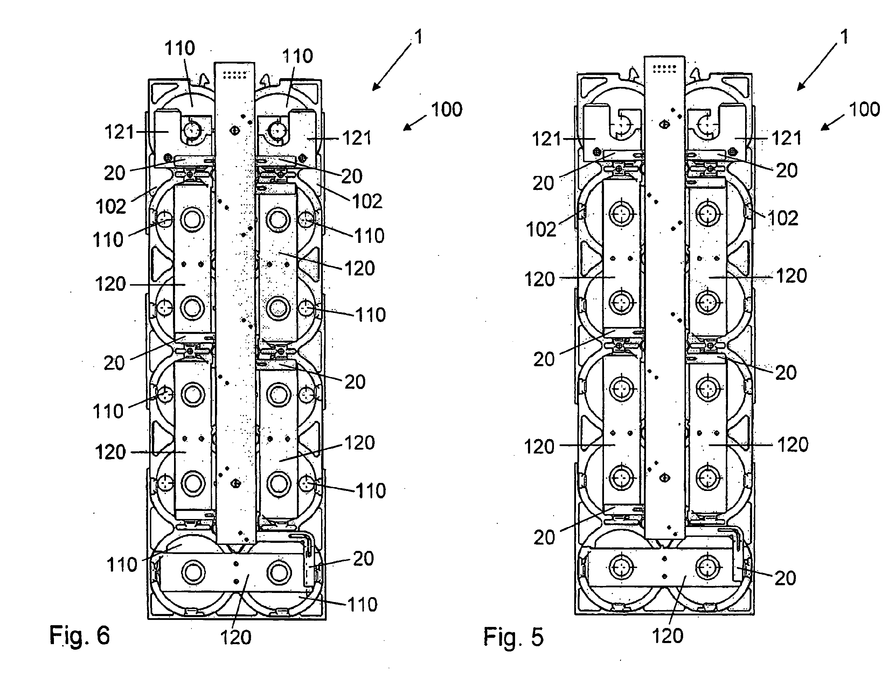

Die Figuren 5 und 6 zeigen jeweils in einer schematischen Draufsicht den Aufbau eines erfindungsgemäßen Energiespeichermoduls einmal ohne Speicherzellen (Fig. 5) und einmal mit Speicherzellen (Fig. 6). Das Energiespeichermodul besteht - lediglich beispielhaft - aus zwei horizontal nebeneinander angeordneten Spalten mit jeweils sechs vertikal übereinander angeordneten Speicherzellen. Jeweilige dem Betrachter in Fig. 6 zugewandte Zellterminals sind alternierend übereinander und nebeneinander angeordnet. Das heißt, dass beispielsweise ein Pluspol der Speicherzelle 110 links unten in einer Ebene mit einem Minuspol der vertikal darüber angeordneten Speicherzelle 110 angeordnet ist. Daraufhin erfolgt in vertikaler Richtung nach oben wieder ein Pluspol, auf den ein Minuspol usw. folgt. Der Pluspol der Speicherzelle 110 links unten ist in einer Ebene mit einem Minuspol der Speicherzelle der horizontal benachbarten Spalte (rechts unten) angeordnet. In vertikaler Richtung über diesen folgt wieder ein Pluspol, auf den ein Minuspol usw. folgt. Jeweils ein Zellverbinder verbindet einen Plus- und einen Minuspol benachbart angeordneter Speicherzellen 110. Insgesamt weist das Energiespeichermodul 100 fünf Zellverbinder 120 auf. Die beiden in vertikaler Richtung obersten Speicherzellen 110 sind mit den bereits erwähnten Modulschwertern 121 verbunden, über die eine Gesamtspannung des Energiespeichermoduls abgegriffen werden kann.

Aus den Figuren 5 und 6 ist gut zu erkennen, dass das erfindungsgemäße Umverdrahtungselement 1 zwischen den beiden vertikal angeordneten Spalten angeordnet ist. Dabei ist dem Betrachter die in Fig. 2 gezeigte Rückseite des Umverdrahtungselements 1 zugewandt. Die elektrische Kontaktierung der Spannungsabgriffe 20 erfolgt auf der dem Betrachter zugewandten Seiten der Zellverbinder 120 einschließlich der Modulschwerter 121 oder gegebenenfalls der jeweiligen Zellterminals der Speicherzellen selbst.

Der in den Figuren 1 und 2 ersichtliche Stecker weist vom Betrachter weg in die Blattebene hinein und ist damit den Speicherzellen zugewandt. Hierdurch ist ein raumoptimiertes Energiespeichermodul 100 bereitgestellt.

Durch die beschriebene Gestalt der Spannungsabgriffe 20 können unterschiedliche Ausdehnungen von Träger 15 und den Zellverbindern bzw. Modulschwertern oder aber auch der in Halteelementen 102 fixierten Speicherzellen ausgeglichen werden.

Eine mechanische Fixierung des Umverdrahtungselements 1 erfolgt bevorzugt nicht nur über die stoffschlüssigen Verbindungen zu den Zellverbindern/Modulschwertem bzw. Speicherzellen, sondern es erfolgt zusätzlich eine Halterung in einem nicht näher dargestellten Halteelement 102. Hieraus ergeben sich montagetechnische Vorteile, da Zellverbinder, Modulschwerter und das Umverdrahtungselement zunächst in einem Halteelement 102 eingebracht und fixiert werden können. Anschließend erfolgt die Herstellung der stoffschlüssigen Verbindung zwischen den Spannungsabgriffen 20 und den Zellverbindern bzw. Modulschwertern. Dieses Halbzeug wird dann auf die Stirnseiten der in den Figuren 5 und 6 beschriebenen Speicherzellen aufgesetzt, woraufhin eine stoffschlüssige Verbindung zwischen den Zellverbindern und den Zellterminals der Speicherzellen erfolgen kann.

Abweichend davon könnte die Herstellung der stoffschlüssigen Verbindungen zwischen den Spannungsabgriffen und den Zellverbindern/Modulschwertern auch in einem gemeinsamen Herstellungsschritt zusammen mit der Herstellung der elektrischen Verbindung zwischen Zellverbindern und Zellterminals erfolgen.

Die Herstellung der stoffschlüssigen Verbindung zwischen Zellterminals und Zellverbindern erfolgt vorzugsweise durch ein Schweißverfahren, wobei bevorzugt Laserschweißung zum Einsatz kommt. Darüber hinaus sind jedoch auch andere Schweißverfahren einsetzbar.

## Patentansprüche

1. Energiespeichermodul-Umverdrahtungselement (1) für ein Energiespeichermodul (100), das aus mehreren, in zumindest einer vertikalen Reihe übereinander angeordneten Speicherzellen (110) besteht, die paarweise über Zellverbinder (120) elektrisch miteinander verschaltet sind, mit
- einer Leiterzugstruktur (10) mit mehreren nebeneinander angeordneten und sich vertikal erstreckenden Leiterbahnen (11),
- mehreren Spannungsabgriffen (20), deren den Leiterbahnen (11) zugewandte, erste Enden (21) jeweils mit einem zugeordneten ersten Ende (12) einer jeweiligen Leiterbahn (11) verbunden sind, und deren freie, zweite Enden (22) zur stoffschlüssigen Verbindung mit zugeordneten Zellverbindern (120) vorgesehen sind, wobei die Spannungsabgriffe (20) und die Leiterzugstruktur (10) koplanar oder in parallel verlaufenden Ebenen angeordnet sind, und die ersten Enden (21) der Spannungsabgriffe (20) in einem ersten Anschlussabschnitt (23) und die zweiten Enden (22) der Spannungsabgriffe (20) in einem zweiten Anschlussabschnitt (24) angeordnet sind, wobei der erste und der zweite Anschlussabschnitt (24) aneinander grenzen und wobei bei zumindest manchen der Spannungsabgriffe (20) der erste Anschlussabschnitt (23) in einem Winkel von 45° bis 135°, insbesondere von 90°, zu dem zweiten Anschlussabschnitt (24) angeordnet ist,
**dadurch gekennzeichnet, dass**
die Spannungsabgriffe (20) als flexibles Bewegungsausgleichselement ausgebildet sind, um im Betrieb des Energiespeichermoduls eine Relativbewegung des Umverdrahtungselements (1) gegenüber den Zellverbindern (120) und/oder unterschiedliche Ausdehnungen des Umverdrahtungselements (1) und der Zellverbinder (120) auszugleichen, wobei hierzu
- der erste und der zweite Anschlussabschnitt (24) mit ineinander übergehenden Schlitzen (26, 27) versehen sind, und/oder
- zumindest manche der Spannungsabgriffe (20) zumindest einen aus der Ebene des jeweiligen Spannungsabgriffs (20) herausragenden Rillenabschnitt (28) aufweisen.

2. Energiespeichermodul-Umverdrahtungselement nach Anspruch 1, **dadurch gekennzeichnet, dass** die Leiterzugstruktur (10) in und/oder auf einer Trägerplatte (15) ausgebildet ist.

3. Energiespeichermodul-Umverdrahtungselement nach Anspruch.2, **dadurch gekennzeichnet, dass** die ersten Enden (21) der Spannungsäbgriffe (20) zumindest einen, aus der Ebene des jeweiligen Spannungsabgriffs (20) herausragenden, Fuß (30, 31) aufweisen, der durch zugeordnete Aussparungen der Trägerplatte (15) gesteckt ist.

4. Energiespeichermodul-Umverdrahtungselement nach Anspruch 1, **dadurch gekennzeichnet, dass** die Spannungsabgriffe (20) und die Leiterzugstruktur (10) einstückig ausgebildet sind.

5. Verfahren zur Herstellung eines Energiespeichermodul-Umverdrahtungselements (1) nach einem der vorhergehenden Ansprüche für ein Energiespeichermodul (100), das aus mehreren, in zumindest einer vertikalen Reihe übereinander angeordneten Speicherzellen (110) besteht, die paarweise über Zellverbinder (120) elektrisch miteinander verschaltet sind, mit den Schritten:
- Herstellen einer Leiterzugstruktur (10) mit mehreren Leiterbahnen (11);
- Herstellen mehrerer Spännungsabgriffe (20), so dass diese als flexibles Bewegungsausgleichselement im Betrieb des Energiespeichermoduls eine Relativbewegung des Umverdrahtungselements (1) gegenüber den Zellverbindern (120) und/oder unterschiedliche Ausdehnungen des Umverdrahtungselements (1) und der Zellverbinder (120) ausgleichen, wobei hierzu erste Enden (21) der Spannungsabgriffe (20) in einem ersten Anschlussabschnitt (23) und zweite Enden (22) der Spannungsabgriffe (20) in einem zweiten Anschlussabschnitt (24) angeordnet sind, wobei der erste und der zweite Anschlussabschnitt (24) aneinander grenzen und wobei bei zumindest manchen der Spannungsabgriffe (20) der erste Anschlussabschnitt (23) in einem Winkel von 45° bis 135°, insbesondere von 90°, zu dem zweiten Anschlussabschnitt (24) angeordnet ist; und zudem der erste und der zweite Anschlussabschnitt (24) mit ineinander übergehenden Schlitzen (26, 27) versehen sind, und/oder zumindest manche der Spannungsabgriffe (20) zumindest einen aus der Ebene des jeweiligen Spannungsabgriffs (20) herausragenden Rillenabschnitt (28) aufweisen,
- jeweils stoffschlüssiges Verbinden der Spannungsabgriffe (20) an deren den Leiterbahnen (11) zugewandten, ersten Enden (21) mit einem zugeordneten ersten Ende einer jeweiligen Leiterbahn (11), wobei die Spannungsabgriffe (20) und die Leiterzugstruktur (10) koplanar oder in parallel verlaufenden Ebenen angeordnet sind.

6. Energiespeichermodul (100), insbesondere für Kraftfahrzeuge, umfassend:
- mehrere, in zumindest einer vertikalen Reihe übereinander angeordnete Speicherzellen (110), die paarweise über Zellverbinder (120) elektrisch miteinander verschaltet sind;
- ein Energiespeichermodul-Umverdrahtungselement (1);
**dadurch gekennzeichnet, dass** das Energiespeichermodul-Umverdrahtungselement (1) gemäß einem der Ansprüche 1 bis 4 ausgebildet ist, wobei die freien, zweiten Enden (22) der Spannungsabgriffe (20) stoffschlüssig mit zugeordneten Zellverbindern (120) verbunden sind.

7. Verfahren zur Herstellung eines Energiespeichermoduls (100), mit den Schritten:
- Herstellen eines Energiespeichermodul-Umverdrahtungselements (1) gemäß einem der Ansprüche 1 bis 4;
- Herstellen eines Energiespeichermoduls (100) mit mehreren, in zumindest einer vertikalen Reihe übereinander angeordneten Speicherzellen (110), die paarweise über Zellverbinder (120) elektrisch miteinander verschaltet sind;
- Herstellung einer stoffschlüssigen Verbindung zwischen freien, zweiten Enden (22) der Spannungsabgriffe (20) mit zugeordneten Zellverbindern (120) unter Verwendung eines Laserschweißgeräts.

## Claims

1. An energy storage module rewiring element (1) for an energy storage module (100) made up of a number of storage cells (110) disposed one above the other in a vertical row and electrically connected in pairs by cell conductors (120), comprising
- a row of conductors (10) comprising a number of strip conductors (11) disposed side by side and extending vertically,
- a number of voltage taps (20) whose first ends (21) facing the strip conductors (11) are each connected to an associated first end (12) of a respective strip conductor (11), whereas their free second ends (22) are adapted for connection via the material to associated cell conductors (120), wherein the taps (20) and the row of conductors (10) are coplanar or in parallel planes, and the first ends (21) of the taps (20) are disposed in a first connecting portion (23) and the second ends (22) of the taps (20) are disposed in a second connecting portion (24), wherein the first and the second connecting portions (24) adjoin one another and wherein, in at least the majority of taps (20), the first connecting portion (23) is disposed at an angle of 45 to 135 , especially 90 , to the second connecting portion (24),
**characterised in that**
- the voltage taps (20) are in the form of flexible motion-compensating elements, in order, during operation of the energy storage module, to compensate movement of the rewiring element (1) relative to the cell connectors (120) and/or differences between the expansion of the rewiring element (1) and the cell connectors (120), to which end
- the first and the second connecting portion (24) have slots (26, 27) merging into one another and/or
- at least the majority of the taps (20) have at least one grooved portion (28) projecting out of the plane of the respective tap (20).

2. An energy storage module rewiring element according to claim 1, **characterised in that** the row of conductors (10) is formed in and/or on a baseplate (15).

3. An energy storage module rewiring element according to claim 2, **characterised in that** the first ends (21) of the voltage taps (20) have at least one foot (30, 31) projecting out of the plane of the respective tap (20) and inserted through suitable recesses in the baseplate (15).

4. An energy storage module rewiring element according to claim 1, **characterised in that** the taps (20) and the row of conductors (10) are constructed in one piece.

5. A method of producing an energy storage module rewiring element (1) according to any of the preceding claims for an energy storage module (100) made up of a number of storage cells (110) disposed one above the other in at least one vertical row and electrically connected in pairs via cell connectors (120), in the following steps:
- producing a row of conductors (10) containing a number of strip conductors (11),
- producing a number of voltage taps (20) in the form of a flexible element for compensating motion during operation of the energy storage module, i.e. motion of the rewiring element (1) relative to the cell connectors (120) and/or differences between the expansion of the rewiring element (1) and the cell connectors (120), wherein first ends (21) of the taps (20) are disposed in a first connecting portion (23) and second ends (22) of the taps (20) are disposed in a second connecting portion (24), wherein the first and the second connecting element (24) adjoin one another and wherein in at least the majority of the taps (20), the first connecting portion (23) is disposed at an angle of 45 to 135 , especially 90 , to the second connecting element (24) and the first and the second connecting portion (24) have slots (26, 27) which merge into one another and/or
- at least the majority of the taps (20) have at least one grooved portion (28) projecting out of the plane of the respective voltage tap (20), and
- in each case the first ends (21), facing the strip conductors (11), of the voltage taps (20) are connected via the material to an associated first end of a respective strip conductor (11), wherein the voltage taps (20) and the line of conductors (10) are coplanar or are in parallel planes.

6. An energy storage module (100), especially for motor vehicles, comprising:
- a number of storage cells (110) disposed one above the other in at least one vertical row and electrically connected in pairs via cell connectors (120), and
- an energy storage module rewiring element (1);
**characterised in that** the energy storage module rewiring element (1) is constructed according to any of claims 1 to 4, wherein the free second ends (22) of the voltage taps (20) are connected via the material to associated cell connectors (120).

7. A method of producing an energy storage module (100) in the following steps:
- producing an energy storage module rewiring element (1) according to any of claims 1 to 4;
- producing an energy storage module (100) comprising a number of storage cells (110) arranged one above the other in at least one vertical row and electrically connected to one another in pairs by cell connectors (120), and
- production of a connection via the material between free second ends (22) of the voltage taps (20) and associated cell connectors (120), using a laser welding device.

## Revendications

1. Elément de câblage (1) de module accumulateur d'énergie destiné à un module accumulateur d'énergie (100) qui est constitué de plusieurs cellules d'accumulation (110) positionnées les unes au-dessus des autres selon au moins une rangée verticale qui sont reliées électriquement entre elles par paires par l'intermédiaire d'un élément de liaison de cellules (120), comportant :
- une structure de lignes conductrices (10) comportant plusieurs pistes conductrices (11) positionnées côte à côte et s'étendant verticalement,
- plusieurs prises de tension (20) dont les premières extrémités (21) tournées vers les pistes conductrices (11) sont respectivement reliées avec une première extrémité (12) associée d'une piste conductrice (11) respective, et dont les secondes extrémités (22) libres sont prévues pour permettre une liaison par la matière avec des éléments de liaison de cellules (120) associés, les prises de tension (20) et les structures de lignes conductrices (10) étant coplanaires ou positionnées dans des plans s'étendant parallèlement, et, les premières extrémités (21) des prises de tension (20) étant situées dans un premier tronçon de liaison (23) tandis que les secondes extrémités (22) des prises de tension (20) sont situées dans un second tronçon de liaison (24), le premier et le second tronçon de liaison (24) étant voisins, et, pour au moins certaines des prises de tension (20) le premier tronçon de liaison (23) étant disposé sous un angle de 45° à 135°, en particulier de 90° par rapport au second tronçon de liaison (24),
**caractérisé en ce que**
les prises de tension (20) sont réalisées sous la forme d'éléments de compensation de déplacement flexibles pour pouvoir compenser, lors du fonctionnement du module accumulateur d'énergie un déplacement relatif de l'élément de câblage (1) par rapport aux éléments de liaison des cellules (120), et/ou des différences de dilatation de l'élément de câblage (1) et de l'élément de liaison de cellules (120), à cet effet :
- le premier et le second tronçon de liaison (24) étant équipés de fentes (26, 27) situées en continuité les unes par rapport aux autres, et/ou
- au moins certaines des prises de tension (20) comportant un tronçon à rainures (28) dépassant du plan de la prise de tension (20) concernée.

2. Elément de câblage de module accumulateur d'énergie conforme à la revendication 1,
**caractérisé en ce que**
la structure de lignes conductrices (10) est réalisée dans et/ou sur une plaque support (15).

3. Elément de câblage de module accumulateur d'énergie conforme à la revendication 2,
**caractérisé en ce que**
les premières extrémités (21) des prises de tension (20) comportent au moins un talon (30, 31) dépassant du plan de la prise de tension (20) concernée, qui est enfiché au travers d'évidements associés de la plaque-support (15).

4. Elément de câblage de module accumulateur d'énergie conforme à la revendication 1,
**caractérisé en ce que**
les prises de tension (20) et la structure de lignes conductrices (10) sont réalisées en une seule pièce.

5. Procédé d'obtention d'un élément de câblage de module accumulateur d'énergie (1) conforme à l'une des revendications précédentes destiné à un module accumulateur d'énergie (100) qui est constitué de plusieurs cellules d'accumulation (110) positionnées les unes au-dessus des autres selon au moins une rangée verticale et qui sont électriquement reliées entre elles par paires par l'intermédiaire d'un élément de liaison de cellules (120), comportant les étapes constant à :
- fabriquer une structure de lignes conductrices (10) comportant plusieurs pistes conductrices (11),
- fabriquer plusieurs prises de tension (20) de sorte que celles-ci puissent, en tant qu'élément de compensation de déplacement flexible, lors du fonctionnement du module d'accumulation d'énergie, compenser un déplacement relatif de l'élément de câblage (1) vis-à-vis des éléments de liaison (120) des cellules et/ou des différences de dilatation de l'élément de câblage (1) et de l'élément de liaison de cellules (120), à cet effet, des premières extrémités (21) des prises de tension (20) étant situées dans un premier tronçon de liaison (23) tandis que les secondes extrémités (22) des prises de tension (20) sont situées dans un second tronçon de liaison (24), le premier et le second tronçon de liaison (24) étant voisins l'un de l'autre, et, pour au moins certaines des prises de tension (20) le premier tronçon de liaison (23) étant positionné sous un angle de 45° à 135°, en particulier de 90° par rapport au second tronçon de liaison (24) et en outre, le premier et le second tronçon de liaison (24) étant équipés de fentes (26, 27) se prolongeant les unes dans les autres, et/ou au moins certaines des prises de tension (20) comportant au moins un tronçon (28) à rainures dépassant du plan de la prise de tension (20) respective,
- liaison respective par la matière des prises de tension (20) à leurs premières extrémités (21) tournées vers les pistes conductrices (11) avec une première extrémité associée d'une piste conductrice (11) respective, les prises de tension (20) et la structure de lignes conductrices (10) étant coplanaires ou étant positionnées dans des plans s'étendant parallèlement.

6. Module accumulateur d'énergie (100) en particulier destiné à des véhicules comprenant :
- plusieurs cellules d'accumulation (110) positionnées les unes au-dessus des autres selon au moins une rangée verticale et qui sont reliées électriquement par paires les unes aux autres par un élément de liaison de cellules (120),
- un élément de câblage de module accumulateur d'énergie (1), **caractérisé en ce que** l'élément de câblage de module accumulateur d'énergie (1) est réalisé conformément à l'une quelconque des revendications 1 à 4,
les secondes extrémités libres (22) des prises de tension (20) étant reliées par une liaison par la matière aux éléments de liaison de cellules (120) associés.

7. Procédé d'obtention d'un module accumulateur d'énergie (100) comportant les étapes consistant à :
- fabriquer un élément de câblage de module accumulateur d'énergie (1) conforme à l'une des revendications 1 à 4,
- fabriquer un module accumulateur d'énergie (100) comportant plusieurs cellules d'accumulation (110) positionnées les unes au-dessus des autres sur au moins une rangée verticale et qui sont reliées électriquement les unes aux autres par paires par un élément de liaison de cellules (120),
- fabriquer une liaison par la matière des secondes extrémités libres (22) des prises de tension (20) avec des éléments de liaison de cellules (120) associés en utilisant un appareil de soudage laser.
